# EUROPEAN PATENT APPLICATION

(11) **EP 2 830 212 A2**
(43) Date of publication of application: **28.01.2015**
(21) Application number: 14163134.1
(22) Date of filing: 02.04.2014
(51) Int. Cl.: H02P 29/00, H02H 1/00, H02H 3/16, G01R 31/34, G01R 31/02, H02H 7/08

(54) **Systems and methods for arc detecting and extinguishing in motors**

(30) Priority: 04.04.2013 US 201361808554 P; 06.03.2014 US 201414198725
(71) Applicant: Hamilton Sundstrand Corporation, Windsor Locks, CT 06096-1010 (US)
(72) Inventor: Said, Waleed M., Rockford, IL Illinois 61114 (US)
(74) Representative: Bridge, Kerry Ann

(57) **Abstract**

A system and method for arc detecting and extinguishing in motors includes a power input interface to a power source 214, 314; an output interface to a motorized load to deliver power to the motorized load; a set of sensors configured to detect an arc condition in the motorized load; a set of switches switchable to provide a low-impedance pathway parallel to the arc condition in the motorized load; and a controller 208, 308, coupled to the power input interface, the output interface, the set of sensors, and the set of switches, the controller being configured to switch the set of switches to disconnect the power source, and activate the low-impedance pathway based on the detection of the arc condition, thereby preventing unintentionally generated energy in the motorized load from sustaining the arc condition.

## Description

### FIELD OF THE INVENTION

The present teachings relate to systems and methods for arc detecting and extinguishing in motors, and more particularly, to platforms and techniques for providing automatic sensing and protection circuitry to reduce or prevent electrical arcing and other faults in brushless DC motors.

### BACKGROUND OF THE INVENTION

In the field of electrical motors, power management and fault detection and isolation are significant concerns. Brushless DC motors, in particular, typically require power electronics controllers to operate correctly. Such motor controllers provide means to detect failures in the motor such as phase to phase and phase to chassis faults. Faults of this type sometimes manifest themselves as electric arcs that result in breakdown of insulations, melting of conductors causing sparks, smoke, and sometimes fires.

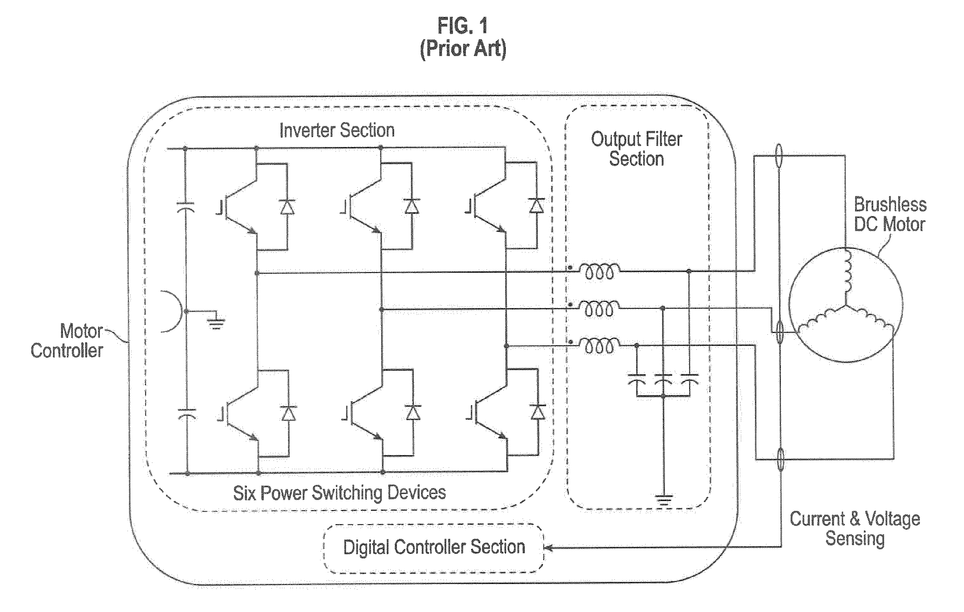

Present motor controllers, such as the unit illustratively shown in FIG. 1, are typically provided with voltage and current sensors which together with their high bandwidth are capable to detect faults that cause the arcs. Known controllers are generally configured to disconnect power from the motor by turning all the power switches in the inverter section of the motor controller that power the motor phases off.

Known controllers as shown may include an inverter section encompassing a minimum of six power switching devices that are used to synthesize voltage waveforms to operate the motor as required. When these devices are turned off, the supply power is disconnected from connected running motor, and the motor will consequently be under the influence of the inertia of the mechanical load. While the motor is driven by the inertia it will operate as a generator which unintentionally feeds existing faults.

Thus, in the case of brushless DC motors, as noted, disconnecting the motor from the power source allows the motor to run free under the influence by the inertia of the load. The motor in this case again will behave like a generator, producing voltage that continues to feed the arc fault (or cause new faults), even though the primary source had been disconnected.

It may be desirable to provide methods and systems for arc detecting and extinguishing in motors, in which both power disconnection, arcing due to reverse motor generation, and motor braking can be provided to protect DC brushless motors which have entered a fault condition.

### BRIEF SUMMARY

According to an aspect of the invention, a system for arc detecting and extinguishing in motors includes a power input interface to a power source; an output interface to a motorized load to deliver power to the motorized load; a set of sensors configured to detect an arc condition in the motorized load; a set of switches switchable to provide a low-impedance pathway parallel to the arc condition in the motorized load; and a controller, coupled to the power input interface, the output interface, the set of sensors, and the set of switches, the controller being configured to switch the set of switches to disconnect the power source, and activate the low-impedance pathway based on the detection of the arc condition, thereby preventing unintentionally generated energy in the motorized load from sustaining the arc condition.

In addition to one or more of the features described above, or as an alternative, further embodiments could include a motorized load that comprises a brushless direct current (DC) motor.

In addition to one or more of the features described above, or as an alternative, further embodiments could include power delivered to the motorized load as three-phase power.

In addition to one or more of the features described above, or as an alternative, further embodiments could include a set of switches that comprises a set of three upper switches, and a set of three lower switches, the set of three upper switches and the set of three lower switches being configured to deliver the three-phase power to the load.

In addition to one or more of the features described above, or as an alternative, further embodiments could include a controller that comprises a programmable controller.

In addition to one or more of the features described above, or as an alternative, further embodiments could include a low-impedance pathway that comprises a safety circuit coupled to ground.

In addition to one or more of the features described above, or as an alternative, further embodiments could include a safety circuit that is in parallel to the arc condition, whereby the safety circuit reduces the voltage of the arc condition below a self-sustaining voltage.

According to another aspect of the invention, a system for arc detecting and extinguishing in motors includes an input interface to a power source; an output interface to a motorized load comprising a stator to deliver power to the motorized load; a set of switches switchable to provide a low-impedance pathway parallel to the motorized load; and a controller, coupled to the input interface, the output interface, the set of sensors, and the set of switches, the controller being configured to switch the set of switches to disconnect the power source, and to activate the low-impedance pathway based on switching conditions in the common motor start controller, thereby draining energy from the stator and braking the motorized load.

In addition to one or more of the features described above, or as an alternative, further embodiments could include a motorized load that comprises a brushless direct current (DC) motor.

In addition to one or more of the features described above, or as an alternative, further embodiments could include power delivered to the motorized load as three-phase power.

In addition to one or more of the features described above, or as an alternative, further embodiments could include the set of switches comprising a set of three upper switches, and a set of three lower switches, the set of three upper switches and the set of three lower switches being configured to deliver the three-phase power to the load.

In addition to one or more of the features described above, or as an alternative, further embodiments could include a controller that comprises a programmable controller.

In addition to one or more of the features described above, or as an alternative, further embodiments could include a low-impedance pathway that comprises a safety circuit coupled to ground.

According to another aspect of the invention, a method for arc detecting and extinguishing in motors, comprising; coupling an input interface to a power source; coupling an output interface to a motorized load comprising a stator to deliver power to the motorized load; coupling a set of switches to the input interface and the output interface, wherein the set of switches being switchable to provide a low-impedance pathway parallel to the motorized load; and coupling a controller to each of the input interface, the output interface, the set of sensors, and the set of switches; wherein the controller is configured to switch the set of switches to: disconnect the power source, and activate the low-impedance pathway based on switching conditions in the common motor start controller, thereby draining energy from the stator and braking the motorized load.

In addition to one or more of the features described above, or as an alternative, further embodiments could include coupling the output interface to a brushless direct current (DC) motor.

In addition to one or more of the features described above, or as an alternative, further embodiments could include delivering power to the motorized load as three-phase power.

In addition to one or more of the features described above, or as an alternative, further embodiments could include coupling a set of switches comprising a set of three upper switches, and a set of three lower switches, the set of three upper switches and the set of three lower switches being configured to deliver the three-phase power to the load.

In addition to one or more of the features described above, or as an alternative, further embodiments could include a controller comprising a programmable controller.

In addition to one or more of the features described above, or as an alternative, further embodiments could include a low-impedance pathway that comprises a safety circuit coupled to ground.

In addition to one or more of the features described above, or as an alternative, further embodiments could include a safety circuit that is in parallel to the arc condition, whereby the safety circuit reduces the voltage of the arc condition below a self-sustaining voltage.

Technical effects of the invention relate to arc detecting and extinguishing in motors. The invention provides systems and methods for controlling DC brushless motors to interrupt the delivery of power, as well as to prevent inertial power generation by the free-spinning motor and achieve motor braking, in the event of an electrical fault.

### BRIEF DESCRIPTION OF THE DRAWINGS

The accompanying drawings, which are incorporated in and constitute a part of this specification, illustrate implementations of the present teachings and together with the description, serve to explain the principles of the present teachings. In the figures:
FIG. 1 illustrates a brushless DC motor control platform, according to known implementations;
FIG. 2 illustrates a brushless DC motor control system, according to various implementations of the present teachings; and
FIG. 3 illustrates a brushless DC motor control system, according to various implementations in further regards.

It should be noted that some details of the FIGS. have been simplified and are drawn to facilitate understanding of the present teachings rather than to maintain strict structural accuracy, detail, and scale.

### DETAILED DESCRIPTION

Implementations of the present teachings relate to systems and methods for arc detecting and extinguishing in motors. More particularly, implementations relate to platforms and techniques for controlling DC brushless motors to interrupt the delivery of power, as well as to prevent inertial power generation by the free-spinning motor and achieve motor braking, in the event of an electrical fault.

Systems and methods according to the present teachings provide techniques to disconnect the main source power to the faulty motor plus, as well as to provide a low impedance path for the voltage generated by the free running motor to deprive the fault of the sustaining power source and extinguish the resultant arc. This method involves a reconfiguration of the power switches only and does not require any added hardware beyond the normally available current and voltage sensors in the motor controller. In motor controllers with programmable microprocessors or digital signal processors, these techniques can be implemented using software or programmable logic.

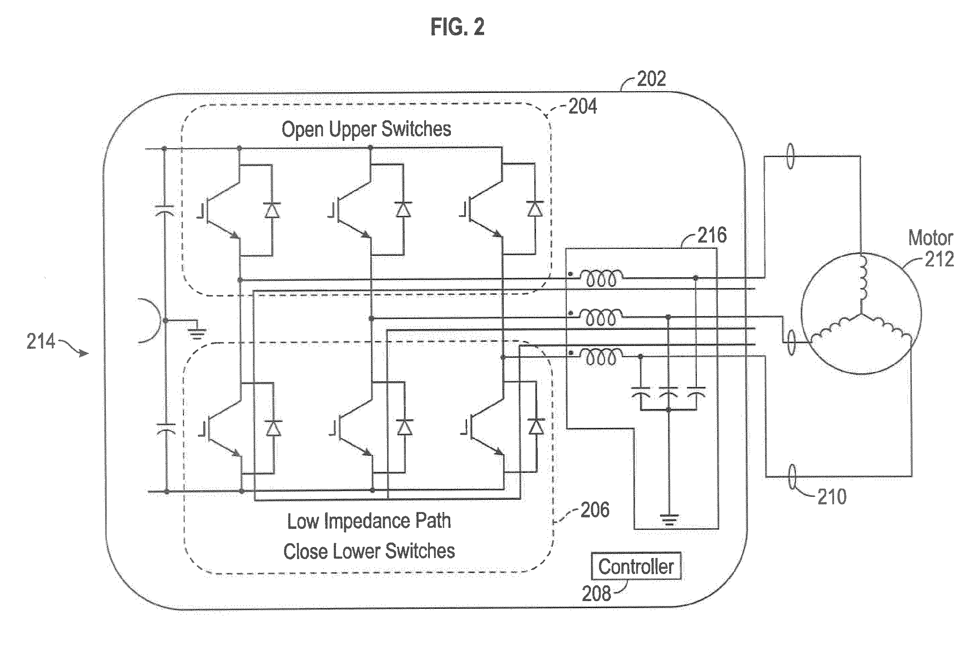

Reference will now be made in detail to exemplary implementations of the present teachings, which are illustrated in the accompanying drawings. Where possible the same reference numbers will be used throughout the drawings to refer to the same or like parts. FIG. 2 illustrates an overall system 202 in which systems and methods for arc detecting and extinguishing in motors can operate, according to aspects. In aspects as shown, FIG. 2 generally shows the motor controller inverter section with its switching devices configured to provide a low impedance path for the motor generated voltage to deprive the fault from that voltage.

More specifically and as for instance illustrated in FIG. 2, the system 202 can be fed by an electrical power source 214, which may be an alternating current (AC) source or other source, and contain a number of modules to control the delivery of power to a motor 212. In implementations, the motor 212 can be or include a brushless DC motor. In further implementations, the load driven by the system 202 can be or include other types of motors, and/or other types of devices, components, or loads. The system 202 can include a set of upper switches 204 shown in the open position, as well as a set of lower switches 206 which can be closed according to the present teachings to prevent arcing or other damage. The system 202 can also include a safety circuit 216, which can include as shown pathways coupled via capacitors to ground. The set of upper switches 204, set of lower switches 206, and safety circuit 216 can be configured as three-phase elements which connect three power signals 120 degrees apart to the motor 212.

The system 202 can include, and operate under the control of, a controller 208, such as a microprocessor, embedded control, digital signal processor, and/or other programmed logic. The controller 208 can communicate with a set of circuit sensors 210, which can include voltage and/or current sensors connected to the three phase lines feeding the motor 212.

In operation, the controller 208 can detect a fault in the motor 212 via the set of circuit sensors 210, such as by detecting an over current, under current, over voltage, under voltage, temperature, and/or other fault condition or conditions. In cases, the fault can be or include a short circuit between any two power phase lines, and/or a short circuit between any one or more phase line and ground. The fault can occur inside the motor 212, and/or outside the motor 212. The fault condition or conditions sensed by the set of sensors 210 can be reported to the controller 208 in real time or essentially real time.

Upon detecting the presence or occurrence of a fault, the controller 208 can operate to cause a set of actions in the set of upper switches 204 and the set of lower switches 206. In particular, as shown in FIG. 2, the controller 208 can cause the set of upper switches 204 to enter an open state. In an open state, the set of upper switches 204 can effectively disconnect the system 202 and ultimately the motor 212 from the power source 214, eliminating the flow of additional power to the system 202 and motor 212. With the power source 214 disconnected, further arcing, burning, or other damage to the system 202 and/or motor 212 can be prevented.

In addition, controller 208 can act to close the set of lower switches 206 upon detection of a fault condition in the motor 212 and/or the delivery of power thereto. Once the set of lower switches 206 are closed, a low impedance path is created from the motor 212 to ground via safety circuit 216, creating a shunt to divert any uncontrolled power generated by the motor 212 when spinning under the inertia of any attached load. In aspects, the shunt pathway can form a parallel connection to ground (or other point) with the arc that is occurring. This parallel low-impedance path will deprive the arc of the self-sustaining voltage necessary to overcome the voltage drop across the arc, and keep the energy flowing through the arc.

It will be appreciated that while a low impedance path is illustrated using the closed-switch low impedance path and safety circuit 216, other circuit connections, configurations, or points can be used to divert unintended power flows to ground or other points and quench the arc that is occurring. By shunting any excess unintentionally generated power from the motor 212 to ground or other point, the possibility of additional arcing or burning is reduced or eliminated.

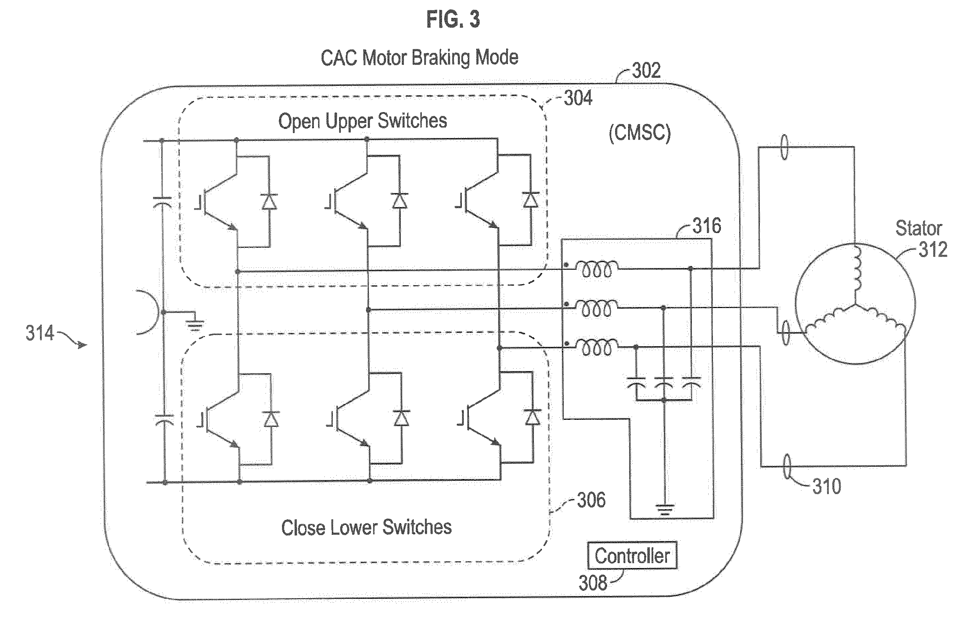

FIG. 3 illustrates a system 302 that can be used in systems and methods to arc detecting and extinguishing in motors, according to further implementations. In the system 302 as shown, the system 302 can include generally similar elements as the system 202 shown in FIG. 2, including a set of upper switches 304, a set of lower switches 306, a safety circuit 316, and a controller 308. As shown, the controller 308 can be coupled to a set of sensors 310, such as voltage, current, and/or other sensors. The system 302 can be connected to a power source 314. The system 302, which can be referred to as a common motor start controller (CMSC), can control and deliver AC, direct current (DC), and/or other types of power. As shown, system 302 can be connected to a stator 312, which can be a static part of a compressor part, such as an aircraft cabin air compressor. It will be appreciated, however, that stator 312 can be contained within other types of compressors, and that power can be delivered to and/or other types of motor-driven devices or loads. For example, the load to which the system 302 is attached can be or include a fuel pump or other motorized assembly.

In implementations shown in FIG. 3, torque is produced by the system 302 operating to switch the set of upper switches 304 and set of lower switches 306 in a predefined sequence controlling current to the motorized load. To actively provide a braking torque to the motor, the system 302 can operate to provide a low-impedance path to short circuit the energy in the stator 312, similar to the shunt operation described in connection with FIG. 2. The set of upper switches 304 and set of lower switches 306 can be controlled via the controller 308 and/or system 302 using a digital signal processor (DSP) or other programmed control logic. As noted, the system 302 can operate to drain residual or remaining voltage form the stator 312, and therefore bring the motorized rotation of the load to a stop, in a braking action. In implementations performing a braking operation in this manner, the energy in the stator 312 may be measured or estimated at worst case load and top speed, in order to determine if the set of upper switches 304 and set of lower switches 306 can handle dissipating that energy plus the energy in the feeders. In implementations, it also may be desirable to determine if other circuits or elements associated with the stator 312, CMSC 314, system 302, and/or other components, such as electromagnetic interference (EMI) filters or others, may affect the capacity or operation of the energy-shunting arrangements of the stator 312, as shown.

The foregoing description is illustrative, and variations in configuration and implementation may occur to persons skilled in the art. For example, while implementations have been described in which a single controller (208, 308) operates to control the upper and lower switches and other elements, in implementations, more than one controller can be used. Similarly, while the controller (208, 308) is illustrative as being integral to the system (202, 302), in implementations, the one or more controllers can be implemented as offboard devices, logic, and/or software, including via the cloud or other Internet resource. Other resources described as singular or integrated can in implementations be plural or distributed, and resources described as multiple or distributed can in implementations be combined. The scope of the present teachings is accordingly intended to be limited only by the following claims.

## Claims

1. A system (202, 302), comprising:
a power input interface to a power source (214, 314);
an output interface to a motorized load to deliver power to the motorized load;
a set of sensors configured to detect an arc condition in the motorized load;
a set of switches (204, 206, 304, 306) switchable to provide a low-impedance pathway parallel to the arc condition in the motorized load; and
a controller (208, 308), coupled to the power input interface, the output interface, the set of sensors, and the set of switches, the controller being configured to switch the set of switches to:
disconnect the power source (214), and
activate the low-impedance pathway based on the detection of the arc condition, thereby preventing unintentionally generated energy in the motorized load from sustaining the arc condition.

2. The system of claim 1, wherein the motorized load comprises a brushless direct current (DC) motor.

3. The system of claim 1, wherein the power delivered to the motorized load comprises three-phase power.

4. The system of claim 1, wherein the set of switches comprises-
a set of three upper switches (204, 304), and
a set of three lower switches (206, 306), the set of three upper switches (204, 304) and the set of three lower switches (206, 306) being configured to deliver the three-phase power to the load.

5. The system of claim 1, wherein the controller (208) comprises a programmable controller.

6. The system of claim 1, wherein the low-impedance pathway comprises a safety circuit coupled to ground.

7. The system of claim 6, wherein the safety circuit (216, 316) is in parallel to the arc condition, whereby the safety circuit reduces the voltage of the arc condition below a self-sustaining voltage.

8. A system (202, 302), comprising:
an input interface to a power source (214, 314);
an output interface to a motorized load comprising a stator (312) to deliver power to the motorized load;
a set of switches (204, 206, 304, 306) switchable to provide a low-impedance pathway parallel to the motorized load; and
a controller (208, 308) coupled to the input interface, the output interface, the set of sensors, and the set of switches, the controller being configured to switch the set of switches to:
disconnect the power source, and
activate the low-impedance pathway based on switching conditions in the common motor start controller, thereby draining energy from the stator and braking the motorized load.

9. The system of claim 8, wherein the motorized load comprises a brushless direct current (DC) motor.

10. The system of claim 8, wherein the power delivered to the motorized load comprises three-phase power.

11. The system of claim 8, wherein the set of switches comprises-
a set of three upper switches (204, 304), and
a set of three lower switches (206, 306), the set of three upper switches and the set of three lower switches being configured to deliver the three-phase power to the load.

12. The system of claim 8, wherein the controller (208, 308) comprises a programmable controller.

13. The system of claim 8, wherein the low-impedance pathway comprises a safety circuit coupled to ground.

14. The system of claim 13, wherein the safety circuit is in parallel to the arc condition, whereby the safety circuit reduces the voltage of the arc condition below a self-sustaining voltage.
